# EUROPEAN PATENT APPLICATION

(11) **EP 0 614 284 A1**
(43) Date of publication of application: **07.09.1994**
(21) Application number: 93120758.3
(22) Date of filing: 23.12.1993
(51) Int. Cl.: H03M 1/08

(54) **Thermochromic compounds, their manufacture and use**

(30) Priority: 01.03.1993 US 24062
(71) Applicant: MOTOROLA, INC., Schaumburg, IL 60196 (US)
(72) Inventor: Park, Sangil, Austin, Texas 78734 (US); Chua-Eoan, Lew, Austin, Texas 78730 (US)
(74) Representative: Hudson, Peter David

(57) **Abstract**

A digital-to-analog converter (DAC) (20) includes a data converter (21) which is susceptible to idling noise. Idling occurs when the DAC (20) receives an idle pattern, which is a digital input signal which corresponds to a analog zero level. The DAC (20) provides an output of the data converter (21) as an output signal while receiving a non-idle input pattern. After the DAC (20) continuously detects the idle pattern for a first predetermined time period, the DAC (20) provides the analog zero level as the output signal. A second predetermined time after the idle pattern disappears, the DAC (20) again provides the output of the data converter (21) as the output signal. The first predetermined time preferably corresponds to a propagation delay through the data converter (21), while the second predetermined time period corresponds to one-half the propagation delay through the data converter (21).

## Description

### Field of the Invention

This invention relates generally to signal processing, and more particularly, to digital-to-analog converters (DACs).

### Background of the Invention

Data converters, including digital-to-analog converters (DACs) and analog-to-digital converters (ADCs), have become important due to the popularity of digital recording devices. For example, a compact disc (CD) player optically reads audio information stored on a CD, and provides this digital signal to an input of a DAC, which converts the digital signal to an analog signal. Because digital technology is used, the sound reproduction is nearly flawless: modern DACs, such as those based on the sigma-delta technique, are able to recover the signal without introducing significant amounts of noise or distortion.

There are two basic techniques used in DACs, the sigma-delta technique and the resistive or capacitive divider technique. The sigma-delta technique is attractive because it achieves high resolution by precise timing instead of precisely-matched on-chip components such as resistors. In addition, the expertise needed to produce thin-film, laser-trimmed analog components is difficult to obtain; whereas, high-speed digital switching capability is commonplace in the semiconductor industry.

A basic sigma-delta DAC receives a digital input signal which is summed with inverse feedback of the output signal to provide an error signal. The error signal is then processed through an integrator and a comparator to provide the analog output signal. The sigma-delta DAC is able to shape the quantization noise out of the audio signal range, and any noise beyond that range is imperceptible to the listener in an ideal implementation. The output of an ideal sigma-delta modulator can thus be used as the DAC analog output signal. However, added filtering is required for non-ideal following amplifier stages because the out-of-band noise tends to intermodulate back into the passband. Sigma-delta modulators also often require oversampled data which would be provided by an interpolator.

Sigma-delta DACs, however, do suffer from inherent drawbacks which make them less suitable for audio applications. For example, known sigma-delta DACs suffer from idling noise. That is, during periods in which the digital input corresponds to an analog zero output, the sigma-delta DAC provides a non-zero analog output signal. For example, a CD has gaps or silent periods between different tracks. During the silent period, the digital code represents an analog zero level. However, the sigma-delta DAC produces noise even though it is reading the digital code corresponding to the analog zero level. There are several sources of this idling noise, including the idling pattern generated by the sigma-delta modulator, background noise in the DAC's components, and noise due to rounding errors from arithmetic computations. In audio applications, the sigma-delta DAC's idling noise will often produce an undesirable hissing sound to the listener. Several techniques may be used to reduce the hissing, such as increasing the accuracy of the arithmetic computations, but some idling noise is inherent in the sigma-delta technique. Thus, a new converter with reduced idling noise would be desirable.

### Summary of the Invention

Accordingly, there is provided, in one form, a digital-to-analog converter (DAC) with reduced idling noise, comprising a data converter, a zero sensing portion, a collector portion, and a switching portion. The data converter receives a digital input signal, and provides an analog signal in response thereto. The data converter is characterized as being susceptible to idling noise. The zero sensing portion senses when the digital input signal has a value corresponding to an analog zero level, and activates a zero detect signal in response thereto. The collector portion provides an enable signal in response to the zero detect signal being activated for a first predetermined time period. The switching portion provides an analog output signal as either the analog signal, or the analog zero level, in response to the enable signal being either deactivated or activated, respectively.

In another form, there is provided a method for reducing idling noise in a digital-to-analog converter (DAC). A digital input signal is received at an input of a data converter. A zero detect signal is activated when the digital input signal has a value corresponding to an analog zero level. An enable signal is provided in response to the zero detect signal being activated for a first predetermined time period. Either an output of the data converter, or the analog zero level, is provided respectively in response to the enable signal being either inactive or active.

These and other features and advantages will be more clearly understood from the following detailed description taken in conjunction with the accompanying drawings.

### Brief Description of the Drawings

FIG. 1 illustrates in block diagram form a digital-to-analog converter (DAC) in accordance with the present invention.

FIG. 2 illustrates in block diagram form the data converter of FIG. 1.

FIG. 3 illustrates in logic diagram form the zero sensing circuit of FIG. 1.

FIG. 4 illustrates a flow chart associated with the collector circuit of FIG. 1.

FIG. 5 illustrates in logic diagram form the analog switch of FIG. 1.

### Detailed Description of a Preferred Embodiment

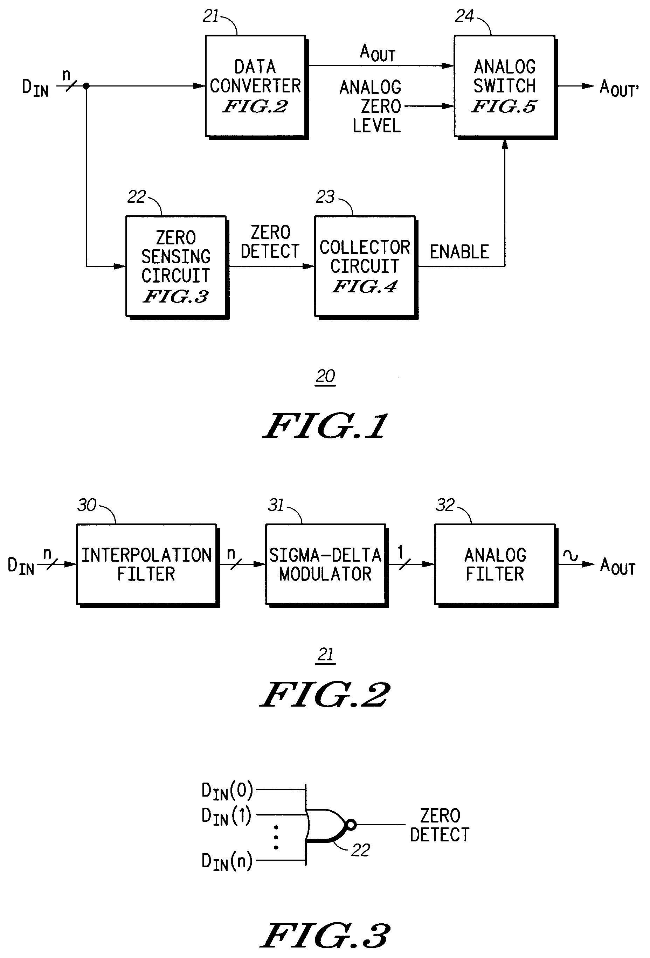

FIG. 1 illustrates in block diagram form a digital-to-analog converter (DAC) 20 in accordance with the present invention. DAC 20 includes a data converter 21, a zero sensing circuit 22, a collector circuit 23, and an analog switch 24. Both data converter 21 and zero sensing circuit 22 receive an n-bit digital input data word, labelled "D_{IN}", at their respective input terminals. Data converter 21 has an output for providing an analog output signal labelled "A_{OUT}". Zero sensing circuit has an output connected to an input of collector circuit 23. Analog switch 24 has a first input for receiving A_{OUT}, a second input for receiving a voltage labelled "ANALOG ZERO LEVEL", a control input for receiving a signal labelled "ENABLE" which is provided at an output of collector circuit 23, and an output for providing a signal labelled A_{OUT'}.

DAC 20 differs from known DACs in that it senses a zero-input condition, and automatically provides an analog zero level as signal A_{OUT'} in response. Zero sensing circuit 22 senses a DAC input code which corresponds to the analog zero level. For most DAC systems, the digital input is represented in fractional two's complement, and the analog zero level is represented as all zeros on D_{IN}. However, some DAC systems represent the analog zero level as a different digital value. For example, 8-bit pulse code modulation (PCM) used in digital telephony represents the zero level as 127. Zero sensing circuit 22 thus differs according to the numerical representation system used.

Collector circuit 23 receives the output of zero sensing circuit 22, and provides signal ENABLE in response to zero sensing circuit 22 detecting the analog zero level for a first predetermined number of consecutive clock periods. The first predetermined number corresponds to the propagation delay of an input signal through data converter 21. Thus, collector circuit 23 only provides signal ENABLE in response to counting a sufficiently long sequence of zeros. Collector circuit 23 provides signal ENABLE continuously until the expiration of a second predetermined number of clock periods after zero sensing circuit 22 detects a non-zero input. It is preferred to make this second predetermined number equal to one-half the propagation delay through data converter 21, since this represents the point in which the output of data converter 21 begins to significantly represent the input digital code at the output. However, it is possible to vary this number and still achieve approximately the same effect.

Analog switch 24 switches between signal A_{OUT} and voltage ANALOG ZERO LEVEL in response to signal ENABLE. If ENABLE is active, then analog switch 24 selects ANALOG ZERO LEVEL and provides ANALOG ZERO LEVEL as A_{OUT'}. If ENABLE is inactive, then analog switch 24 selects A_{OUT} and provides A_{OUT} as A_{OUT'}. Thus, analog switch 24 selects between one of two analog input signals based on a digital signal, and provides the selected analog input signal as an analog output signal.

Data converter 21, zero sensing circuit 22, collector circuit 23, and analog switch 24 will be more clearly understood in the following figures and the accompanying description. However, it is to be understood that for each element of DAC 20, many variations or alternatives are possible.

FIG. 2 illustrates in block diagram form data converter 21 of FIG. 1. Data converter 21 is a sigma-delta DAC which includes an interpolation filter 30, a sigma-delta modulator 31, and an analog filter 32. Interpolation filter 30 receives D_{IN} at a relatively low sampling rate at an input thereof, and interpolates D_{IN} to a higher sampling rate suitable for processing by a sigma-delta modulator 31. For example, interpolation filter 21 may interpolate D_{IN} from 50 kilohertz (kHz) to 3.2 megahertz (MHz). Interpolation filter 30 is a digital filter which includes a digital comb filter, a finite impulse response (FIR) filter, or the like to achieve the interpolation.

Modulator 31 is a fourth-order, one-bit sigma delta modulator which provides a one-bit output signal whose density corresponds to the analog signal. Analog filter 32 receives the output of modulator 31 and provides output signal A_{OUT} in response. Analog filter 32 is a filter which attenuates the quantization noise which sigma-delta modulator 31 shapes out-of-band, and thus provide A_{OUT} with a high signal-to-(noise + distortion) ratio.

Data converter 21 has an associated propagation delay, which is also known variously as the group delay, pipeline delay, or state buffer delay. This delay is due to the fact that interpolation filter 30 is a digital filter such as an FIR filter which interpolates the input data based on past history of the signal. In addition, fourthorder modulator 31 adds four clocks of delay, and analog filter 32 has an associated slew rate. The overall propagation delay, while on the order of thousands of high speed clocks, is small compared to the input sampling period. The net effect of all these delays is that it takes about one-half the overall propagation delay of modulator 21 before A_{OUT} represents D_{IN} in a substantial way.

FIG. 3 illustrates in logic diagram form zero sensing circuit 22 of FIG. 1. In the illustrated embodiment, zero sensing circuit 22 is an n-bit NOR gate with n inputs each for receiving a corresponding bit of input signal D_{IN}, labelled "D_{IN}(j)", and an output for providing signal ZERO DETECT. Illustrated in FIG. 3 are representative inputs for receiving signals D_{IN}(0), D_{IN}(1), and D_{IN}(n). Zero sensing circuit 22 activates ZERO DETECT at a logic high voltage in response to each bit of D_{IN}(j) being a logic low. However, as noted earlier, other logic configurations for zero sensing circuit 22 will be required for different numerical representation systems. In addition, the NOR function may be implemented in two or more logic levels if the particular manufacturing technology used does not allow logic gates with enough inputs to accommodate all n bits.

FIG. 4 illustrates a flow chart 50 associated with collector circuit 23 of FIG. 1. First, the idle condition (ZERO DETECT = 1) is sensed at step 51. If a non-idle condition is sensed within the propagation delay of data converter 21, at step 52, then collector circuit 23 returns to step 51 to sense the occurrence of the next idle condition. However, if collector circuit 23 senses the idle condition for a time period equal to the propagation delay of data converter 21, at step 53, then collector circuit enables the ANALOG ZERO LEVEL as the output of DAC 20 at step 54, by activating signal ENABLE. As long as collector circuit 23 still senses the idle condition (ZERO DETECT = 1), at step 55, signal ENABLE remains active. However, when collector circuit 23 senses a non-idle condition (ZERO DETECT = 0) at step 56, collector circuit 23 keeps signal ENABLE active for a time period equal to one-half the propagation delay of data converter 21, at step 57. Afterward, collector circuit 23 deactivates signal ENABLE, and returns to a step 51 to sense the next idle condition. The steps in flow chart 50 correspond to a finite state machine implemented by collector circuit 23. Preferably, the state machine is implemented with a modulo counter and random logic, but may also be implemented in any other conventional way.

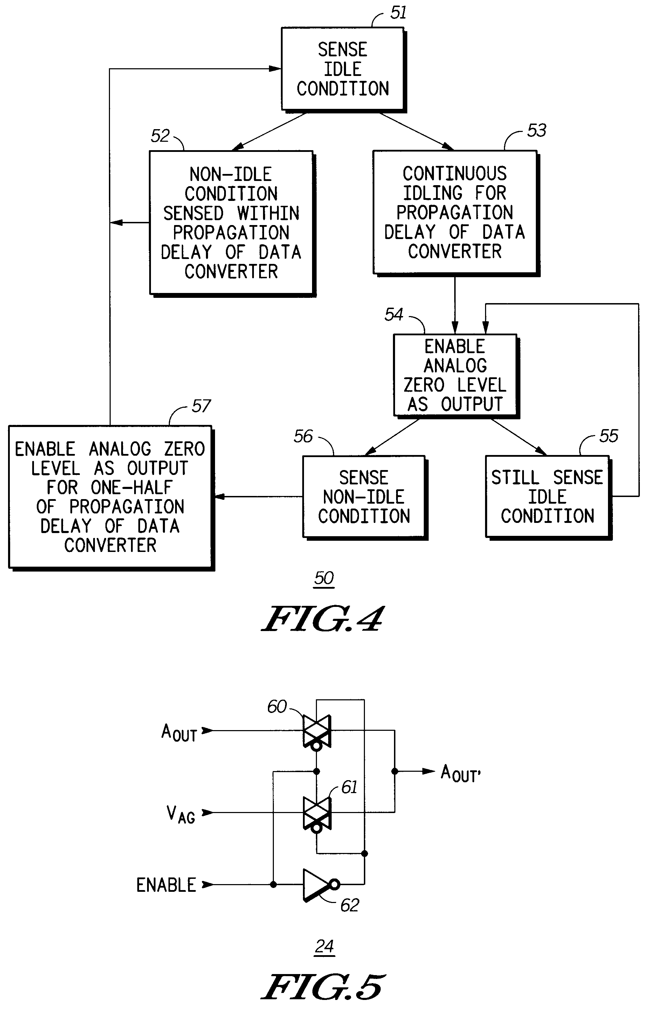

FIG. 5 illustrates in logic diagram form analog switch 24 of FIG. 1. Analog switch 24 includes transmission gates 60 and 61, and an inverter 62. Transmission gate 60 has a first terminal for receiving signal A_{OUT}, a second terminal for providing signal A_{OUT'}, a true control input terminal, and a complementary control input terminal for receiving signal ENABLE. Transmission gate 61 has a first terminal for receiving a voltage labelled "V_{AG}", a second terminal for providing signal A_{OUT'}, a true control input terminal for receiving signal ENABLE, and a complementary control input terminal. V_{AG} is an analog ground voltage which is midsupply and represents the ANALOG ZERO LEVEL when a single-ended analog output signal is provided. Inverter 62 has an input terminal for receiving signal ENABLE, and an output terminal connected to the true control input terminal of transmission gate 60 and to the complementary control input terminal of transmission gate 61. It should be apparent that other configurations for analog switch 24 are also possible, however.

While the invention has been described in the context of a preferred embodiment, it will be apparent to those skilled in the art that the present invention may be modified in numerous ways and may assume many embodiments other than that specifically set out and described above. For example, a DAC according to the present invention may include a first-, second-, or third-order sigma-delta modulator. Also, a DAC according to the present invention may be constructed with non-sigma-delta data converters which are also susceptible to idling noise. While fractional two's complement numbering is by far the most prevalent, a DAC according to the present invention may accommodate alternate numerical representations. Furthermore, the ratio between the time to enable the output of the data converter and the propagation time through the data converter may be varied from the preferred value of one-half. Accordingly, it is intended by the appended claims to cover all modifications of the invention which fall within the true spirit and scope of the invention.

## Claims

1. A digital-to-analog converter (DAC) (20) with reduced idling noise, comprising:
an input port for receiving a digital input signal;
an output port for providing an analog output signal;
a data converter (21) having an input terminal coupled to said input port, and an output terminal for providing an analog signal;
a zero sensing circuit (22) having an input terminal coupled to said input port, and an output terminal for activating a zero detect signal in response to said digital input signal having a value corresponding to an analog zero level;
collector means (23) for receiving said zero detect signal, and for activating an enable signal in response to said zero detect signal being activated for a first predetermined time period; and
an analog switch (24) having a first input terminal for receiving said analog signal, a second input terminal for receiving a predetermined voltage, a control input terminal for receiving said enable signal, and an output terminal coupled to said output port.

2. The DAC (20) of claim 1 wherein said first predetermined time period is equal to a propagation delay through said data converter (21).

3. The DAC (20) of claim 1 wherein said data converter (21) is characterized as being a sigma-delta DAC (21).

4. The DAC (20) of claim 1 wherein said collector means (23) further deactivates said enable signal a second predetermined time period after said zero sensing circuit (22) deactivates said zero detect signal.

5. The DAC (20) of claim 4 wherein said second predetermined time period is equal to one-half of a propagation delay through said data converter (21).

6. The DAC (20) of claim 1 wherein said predetermined voltage is an analog ground voltage.

7. The DAC (20) of claim 1 wherein said analog switch (24) comprises: first switching means (60) for coupling said output
terminal of said data converter (21) to said output port responsive to said enable signal being inactive; and
second switching means (61) for coupling said predetermined voltage to said output port responsive to said enable signal being active.

8. The DAC (20) of claim 1 wherein said zero sensing circuit (22) comprises NOR gate means (22) having inputs receiving respective bits of said digital input signal, and an output terminal for providing said zero detect signal.

9. A digital-to-analog converter (DAC) (20) with reduced idling noise, comprising:
data conversion means (21) for receiving a digital input signal, and for providing an analog signal in response thereto, said data conversion means (21) characterized as being susceptible to idling noise;
zero sensing means (22) for sensing when said digital input signal has a value corresponding to an analog zero level, and for activating a zero detect signal in response thereto;
collector means (23) for providing an enable signal in response to said zero detect signal being activated for a first predetermined time period; and
switching means (24) for providing an analog output signal as either said analog signal, or said analog zero level, in response to said enable signal being either deactivated or activated, respectively.

10. A method for reducing idling noise in a digital-to-analog converter (DAC) (20), comprising the steps of:
receiving a digital input signal at an input of a data converter (21);
activating a zero detect signal when said digital input signal has a value corresponding to an analog zero level;
providing an enable signal in response to said zero detect signal being activated for a first predetermined time period; and
providing either an output of said data converter (21) or the analog zero level as an output of the DAC (20) respectively in response to said enable signal being either inactive or active.
